# EUROPEAN PATENT SPECIFICATION

(11) **EP 0 337 709 B1**
(45) Date of publication and mention of the grant of the patent: **15.12.1993**
(21) Application number: 89303529.5
(22) Date of filing: 11.04.1989
(51) Int. Cl.: H01F 7/22, H01L 39/14

(54) **Magnetic flux transmission system**
Magnetflussübertragungssystem
Système de transmission de flux magnétique

(30) Priority: 14.04.1988 JP 92038/88
(43) Date of publication of application: 18.10.1989
(73) Proprietor: KABUSHIKI KAISHA TOSHIBA, Kawasaki-shi, Kanagawa-ken 210 (JP)
(72) Inventor: Wada, Ichiro c/o Intellectual Property Division, Minato-ku Tokyo (JP)
(74) Representative: BATCHELLOR, KIRK & CO.

(56) References cited:
- GB-A- 1 026 762
- GB-A- 1 121 559
- US-A- 3 091 702
- US-A- 3 158 794
- US-A- 3 500 269
- PATENT ABSTRACTS OF JAPAN vol. 11, no. 288 (E-542)(2735) 17 September 1987, & JP-A-62 89308 (SUMITOMO ELECTRIC IND LTD)

## Description

This invention relates to a magnetic flux transmission system.

Conventionally, various types of electrical devices have been developed using magnets, transformers or choke coils, etc., as devices for efficiently utilising magnetic flux generated thereby. However, to transmit magnetic flux from one location to another, it is necessary to use a solenoid having a length about the same as the transmission distance. If the coil length is very great, this is uneconomic, and lacking in practicality.

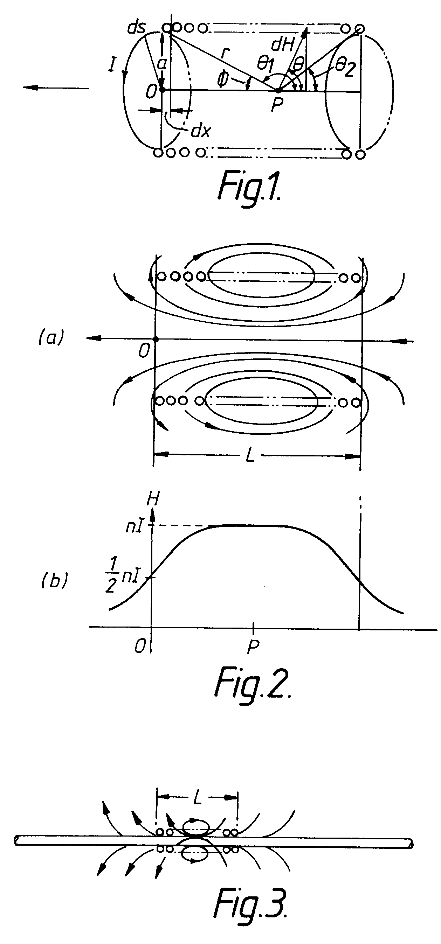

The following calculation explains the reasons why magnetic flux cannot be transmitted over long distances. Referring to Figure 1 of the accompanying drawings, current I flows in a circular circuit consisting of a coil of one turn, the direction of the magnetic flux at the centre point O is the direction which is perpendicular to the plane of the circular circuit. In a vacuum, magnetic field dH of point O obtained from linear element ds of prescribed length can be found by the Biot-Savart Law by:

$\text{dH = [I/(4πa²)] ds (1)}$

Consequently, the magnetic field H obtained from the complete circuit is:

$\text{H = ∫dH = ∫[I/(4πa²)] ds}$
$\text{= I/2a (2)}$

where $\text{∫ds = 2πa}$ . The above equation (2) gives the field obtained for one turn at the left-most end in Figure 1. However, clearly, in the case of n turns,

$\text{H = nI/2a (3)}$

The intensity of the magnetic field at a point P on the axis of the circular circuit is next described. The magnetic field dH at point P obtained from linear element ds is perpendicular to ds and distance r, so, based on the object concept, the effective amount of the entire magnetic field is the component in the OP direction.

$\text{The component of dH in the OP direction = [ (Ids)/(4πr²) ] sin φ}$ , so:
$\text{H = ∫[(Ids)/(4πr²)] sin φ}$
$\text{= [(aI)/(2r²)] sin φ}$
$\text{= a² I/2r³ (4)}$

If it is assumed that $\text{OP = x}$ ,

${\text{H (x) = Ia²/[2(a² + x²)}}^{\text{3/2}} \text{] (5)}$

is obtained. If it is provisionally assumed that there are n circular circuit turns, then

${\text{H = nIa²/[2(a² + X²)}}^{\text{3/2}} \text{] (6)}$

The intensity of the magnetic field at a point other than on the axis cannot easily be found. However, the approximate magnitude of the magnetic field can be inferred from Figure 2, as will be explained.

An example of a magnetic field created by a single-layer winding solenoid will be used for simplicity in calculation. If it is assumed that the number of turns per unit length of the solenoid is n, its radius is a, and that it is wound with uniform thickness on a cylinder, the intensity of the magnetic field at a point P on its centre axis is:

${\text{dH = (nIa² dx)/2[(a² + x²)}}^{\text{3/2}} \text{] (7)}$

where $\text{x = a cos ϑ}$ , $\text{dH = -(1/2) nI sin ϑ d ϑ}$ , so: 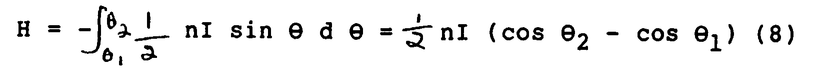
Consequently, if point P is in the neighbourhood of the middle of a solenoid of sufficient length, cos ϑ₁ = 0, cos ϑ₂ approximately equals + 1, so, from above equation (8),

$\text{H = nI (9)}$

and, at point O at the end of the solenoid,
cos ϑ₁ = 0, cos ϑ₂ approximately equals + 1,
so, from equation (8):
and, at end O of the solenoid,

$\text{H = (1/2) nI (10)}$

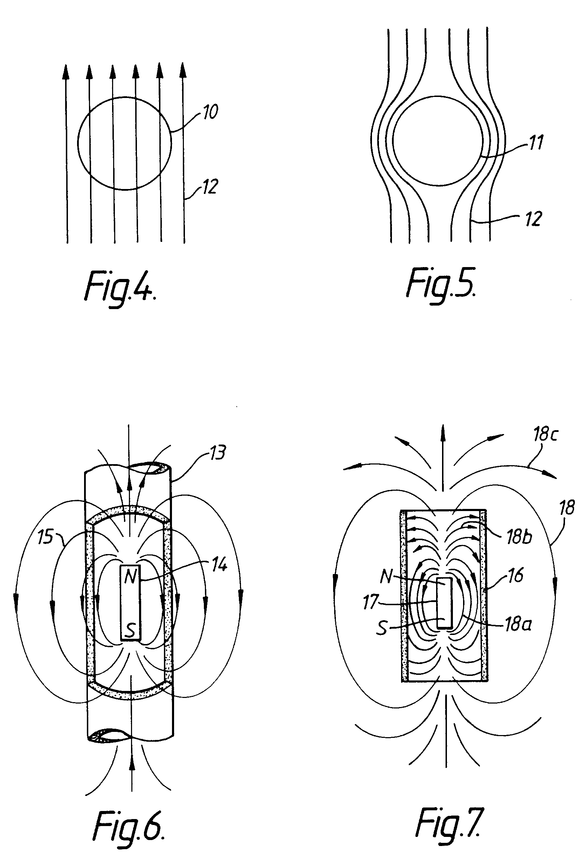

As shown in Figure 2, there is a rapid reduction in the intensity of the magnetic field at the end of the solenoid. As is apparent from equation (9) and equation (10), it is one half that at the centre. This means that, with a conventional magnetic flux generating device using an iron core, or in the case of an air-cored coil described above, at a distance beyond length L of the windings, the magnetic flus leaks to the outisde. As shown in Figure 3, this causes an abrupt decrease in the magnetic field which makes transmission of magnetic flux over a long distance difficult.

US-A-3 091 702 discloses a system which includes a magnetic flux generator which comprises a first geometric solid having an external surface, an external diameter, an axis, a predetermined width, and a first predetermined axial length for generating a magnetic field; and transmitting means which comprises an elongated second geometric solid, mounted to and coaxially disposed relative the magnetic flux generator.

It is an object of this invention to provide an efficient long-distance transmission of magnetic flux.

The invention provides a magnetic flux transmission system comprising a magnetic flux generator comprising a first geometric solid having an external surface, an external diameter, an axis, a predetermined width, and a first predetermined axial length, for generating a magnetic field; and transmitting means comprising an elongated second geometric solid, mounted to and coaxially disposed relative the magnetic flux generator, characterised in that the transmitting means is a tubular member having at least a portion thereof made of superconducting material, the internal diameter of the internal surface of the portion being substantially the same as the external diameter of the magnetic flux generator which is mounted within the member, the transmitting means having a second predetermined axial length greater than the first predetermined axial length defining a channel for transmitting the generated magnetic field along the channel.

Conveniently, the internal diameter of the transmision means is substantially the same as the external diameter of the magnetic flux generator for only the first predetermined axial length.

The transmitting means may be configured to form a closed loop magnetic path.

In order that the invention may be more readily understood, it will now be described, by way of example only, with reference to the accompanying drawings, in which:-
Figure 1 is a diagrammatic representation of the principles involved in the transmission of magnetic flux;
Figure 2 is a diagrammatic representation of a magnetic field created by solenoid;
Figure 3 is a diagram illustrating magnetic flux leakage;
Figure 4 is a diagram illustrating the magnetic characteristics of the conventional conductor;
Figure 5 is a diagram illustrating the characteristics of a magnetic field in a superconductor;
Figure 6 is a diagram illustrating the characteristics of a magnetic field generated by a magnet disposed within the conventional tubular conductor;
Figure 7 is a diagram illustrating the characteristics of a magnetic field generated by a magnet disposed within a tubular conductor of superconductive material;
Figure 8 is a sectional view of a magnetic flux transmission system in accordance with a first embodiment of the present invention;
Figure 9 is a sectional view of a magnetic flux transmission system in accordance with a second embodiment of the present invention;
Figure 10 is a schematic illustration of a flux transmission path in accordance with a third embodiment of the present invention;
Figure 11 schematically illustrates a magnetic flux transmission system with the flux generating device disposed outside the transmission path according to a fourth embodiment of the invention;
Figure 12 is a fragmentary sectional view of the magnetic flux transmission system of Figure 11;
Figure 13 is a fragmentary sectional view of a magnetic flux transmission system with the generator outside the transmission path in accordance with a fifth embodiment of the invention;
Figures 14 and 15 are fragmentary sectional views of the sectional views of the fifth embodiment of the invention with heating elements for the transmission path;
Figure 16 is a fragmentary sectional view of a narrow core in a transmission path;
Figure 17 is a fragmentary sectional view of a transmission path with a wide core;
Figure 18a is a cross-sectional view schematically illustrating a band-shaped core for the flux transmission system of the present invention;
Figure 18b is a cross-sectional view schematically illustrating a multiple wire core for the flux transmission path of the present invention;
Figure 18c is a cross-sectional view illustrating a solid type core for the flux transmission path of the present invention;
Figure 18d is a cross-sectional schematic view of a single cored wire solenoid core for the flux transmission path of the present invention;
Figure 19a schematically illustrates a transmission path where the superconductor flux transmission path is in the form of a fibre wound on a core;
Figure 19b is a schematic view of a flux transmission path where a superconductor is made to adhere tightly to a core, such as by drawing;
Figure 19c is a schematic view showing a flux transmission path where the superconductor is in the form of a powder bonded, sintered, or spray coated on the core;
Figure 20 schematically illustrates a flux transmission system similar to Figure 9 provided with data transmission capabilities; and
Figures 21 and 22 each schematically illustrate a type of data transmission device for the system of Figure 20.

Before explaining the several embodiments of a system according to this invention, a brief explanation will be given of the principles whereby a superconducting material can transmit magnetic flux without leakage to the outside. In general, and as shown in Figure 4, a magnetic field goes straight through the interior of an ordinary conductor 10. However, if, instead of ordinary conductor 10, a superconductor 11 is used, for example, as shown in Figure 5, a magnetic field in the opposite direction is created at the surface, without magnetic field 12 passing through the interior of superconductor 11. Thus, the superconductor has what is known as the property of rejecting ingress of magnetic fields from the outside. That is, if a conventional or ordinary conductor 10, such as metal, is placed in a magnetic field, the electrons are subjected to a Lorentz force, while performing circular motion, and create a diamagnetic current in ordinary conductor 10. However, in a superconductor 11, this diamagnetic current is extremely large, with the result that the magnetic field created by this current cancels the magnetic field from the outside. Furthermore, superconductor 11 has no electrical resistance, even if a current flows in it, so a magnetic field cannot exist in its interior.

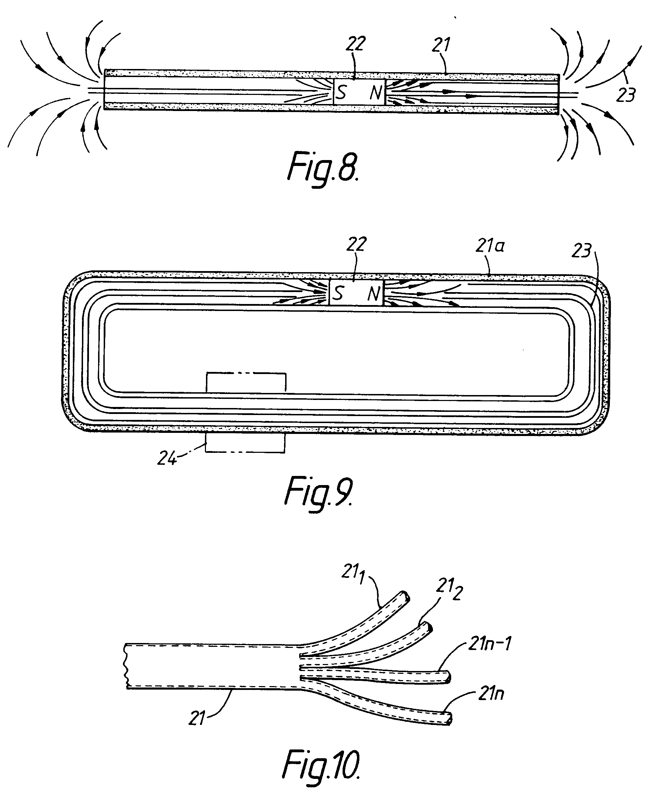

Accordingly, as shown in Figure 6 and Figure 7, a magnetic flux path is obtained when the properties of such a superconductor are effectively utilised by employing a tubular conductor and a magnet or coil is disposed in the interior thereof. Specifically, in Figure 6, when a magnet 14 is disposed in the interior of an ordinary conductive tube or pipe 13, a closed magnetic path is formed whereby the magnetic flux 15 generated, from, for example, the N pole of this magnet, passes through the outside of pipe 13 and practically all this flux enters the S pole. As a result, magnetic flux 15 cannot be transmitted to a remote location.

In contrast, when a magnet 17 is disposed within a superconducting pipe 16, as shown in Figure 7, a part 18a of the magnet flux 18 issuing from N pole of this magnet 17 passes through the bore in pipe 16 to the S pole, while another part 18b stays within the inside wall of pipe 16, and the remaining flux 18c leaves through one end of pipe 16 and returns through the other end of the pipe to enter the S pole of magnet 17. Consequently, of the above-mentioned parts of the magnetic flux, if the external diameter of magnet 17 is practically the same as the internal diameter of pipe 16, and is arranged such that no gap is produced, this magnetic path of flux 18a can be eliminated. Also, if pipe 16 is made long, magnetic flux 18c can be greatly reduced and, as a result, practically all of the magnetic flux generated from the N pole can be collected within the inside wall of pipe 16.

Accordingly, the system of this invention is realised by combining the results of the above description. Embodiments of this invention are described hereinafter.

Figure 8 is a view showing a first embodiment of the device of this invention. There is provided a magnetic flux transmission path 21 having an arbitrarily fixed prescribed length and constructed of a superconducting material. At a prescribed part inside this magnetic flux transmission path 21, there is arranged a magnetic flux generating device 22 which may be, for example, a d.c. magnetised magnet, an a.c. magnetised magnet, or an a.c. magnetising coil, etc., having an external diameter practically equal to the internal diameter of this magnetic flux transmission path 21. Superconducting magnetic flux transmission path 21 may be, for example, of type 1 superconducting materials (Al, No, Pb, Sn, etc.) or of type 2 superconducting materials (Nb, V and oxides, etc.). However, in fact, type 1 are extremely pure metals which do not permit escape of magnetic flux 23 and are, therefore, preferred. On the other hand, type 2 materials are alloys or chemical compounds where ordinary conductive material is mixed in the interior thereof, so some magnetic flux 23 will partially pass therethrough but, with further technical advance, such type 2 materials may be utilised, or, where the magnetic flux is not to be transmitted a particularly great distance, or where magnetic coupling is not essential, either type 1 or type 2 may be used. Also, for superconducting materials that are to be used in atmospheres containing moisture, or special atmospheres (acid, alkali, or organic etc., gases or splashes), or that are to be used by remaining in such atmospheres, a resin coating in accordance with the type of atmosphere (for example, epoxy resin, polyfluoroethylene, polyester resin, formaldehyde resin or the like), rubber lining, or glass lining, etc., must be used. The interior of the tubular superconducting magnetic flux transmission path 21 may be filled with gas, liquid, powder or solid material. The material that increases transmission efficiency of magnetic flux 23 is particularly preferred.

Consequently, with the construction of the first embodiment as above, practically all of the magnetic flux 23 generated from N pole of magnetic flux generating device 22 passes through the bore inside superconducting magnetic flux transmission path 21, or through the inside wall of magnetic flux transmission path 21, and is transmitted to one open end. From this open end, theoretically, it passes through the air and enters the other open end, returning to S pole of magnetic flux generating device 22. Consequently, in this system, the magnetic flux 23 generated from magnetic flux generating device 22 can be transmitted efficiently to an arbitrarily fixed prescribed distance and, if a device utilising magnetic flux, for example, a transformer or magnetic flux sensitive element or other device, is arranged in a prescribed position, the magnetic flux 23 can be effectively utilised.

It should be noted that, in Figure 8, superconducting magnetic flux transmission path 21 is open at both ends. However, as shown in Figure 9, a magnetic flux transmission path 21 may be employed which is in the form of a closed loop. In this embodiment, a magnetic flux utilising device 24 is arranged in the closed loop transmission path 21.

With a configuration as in the embodiment of Figure 9, magnetic flux utilising device 24 can utilise the magnetic flux in close coupling, or it can utilise the magnetic flux reliably and effectively at a location that is quite distant from the generating device 22.

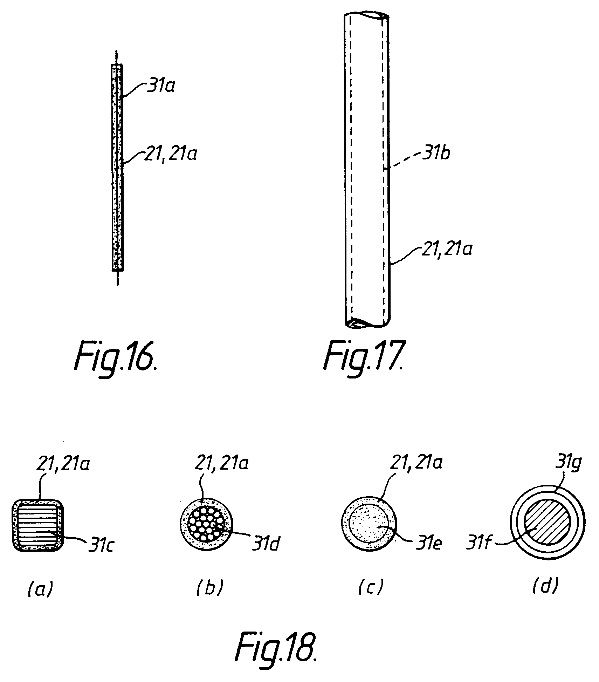

As shown in the embodiment of Figure 10, magnetic flux transmission path may be divided into a plurality of branch paths 21₁, 21₂, ..., at suitable locations corresponding to the locations of disposition of magnetic flux utilising devices 24. It should be noted that, in this embodiment, a construction could be adopted wherein flexibility is provided by inserting a core, as shown in Figures 16, 17 or 18, respectively, for example, as described below, in these branch paths 21₁, 21₂, ...

In particular, a plurality of branches are particularly effective when magnetic flux is fed into magnetic elements, such as silicon wafer glass, etc., made, for example, by micro machining. Also, an alternative construction, where a plurality of magnetic flux transmission paths 21 are brought together, is effective for controlling the micro-machining of a silicon wafer, for example, and when two-phase or three-phase, i.e., multi-phase, magnetic flux is transmitted.

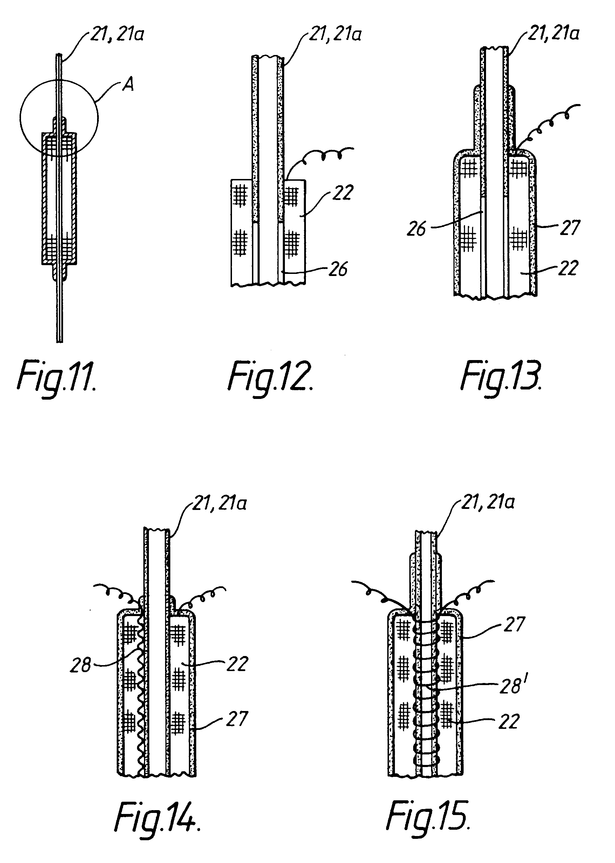

Magnetic flux generating device 22 may be provided in the interior of the magnetic flux transmission path 21, as shown in the embodiments of Figure 8 and Figure 9. However, as shown, for example, in the embodiment of Figure 11, a magnetic flux generating device may be arranged outside. This specific construction can be realised, as shown in Figures 12 to 15 which are enlargements of part A in Figure 11.

Figure 12 shows an embodiment in which the portion of magnetic flux transmission path 21, where magnetic flux generating 22 is mounted, is cut away exposing non-superconducting part 26. Straddling non-superconducting part 26, for example, is the end portion of a magnetic flux generating device which may be of the coil type, for example, and is provided outside superconducting magnetic flux transmission path 21.

Figure 13 is a configuration wherein magnetic flux generating device 22 is the same as in Figure 12 except that the outside of magnetic flux generating device 22 is magnetically shielded by a cover of superconductive material 27. An end of the magnetic flux generating device 22 may be enclosed by the superconductor 27.

Next, in the embodiments of Figure 14 and Figure 15, a heater is provided where magnetic flux generating device 22 surrounds the magnetic flux transmission path 21. The heater is between the magnetic flux transmission path 21 and the magnetic flux generating device 22. The heater 28 may be axial (Figure 14) or there may be provided a helical wound heater 28′ (Figure 15). Heaters 28, 28′, when energised, cause the loss of the superconduction function in part of magnetic flux generating device 22 where they are installed preventing the magnetic flux generated by magnetic flux generating device 22 from being fed into magnetic flux transmission path 21. It should be noted that superconductor 27 may be omitted, as shown in Figure 12, or it may be provided on the outside of magnetic flux generating device 22, as shown in Figure 13.

Consequently, with the construction as above, magnetic flux can easily be transmitted from magnetic flux generating device 22 utilizing junction locations of non-superconducting and superconducting magnetic flux transmission path 21, as shown, for example, in Figure 12 and Figure 13. Moreover, there is a large contribution to the power of the magnetic flux, if magnetic flux generating devices 22 are arranged in this way at each of such junction locations. Also, in Figure 14 and Figure 15, magnetic flux generating device 22 may be installed, without damaging the superconducting properties of magnetic flux transmission path 21, at suitable locations of magnetic flux transmission path 21. Also, supply of the magnetic flux can be achieved at times when it is required by controlling power to heaters 28, 28'.

Further, a core can be inserted in magnetic flux transmission path 21, as shown, for example, in Figure 16, Figure 17 and Figure 18, in order to increase the efficiency of transmission of the magnetic flux generated from magnetic flux generating device 22, or as part of the function of magnetic flux generating device 22. Figure 16 is an example where a narrow core 31a, having a diameter or cross-section smaller than path 21, is inserted into magnetic flux transmission path 21. Figure 17 is an example where a wide core 31b, having a diameter or cross-section as large as the inner cross-section of path 21, is inserted therein. Figures 18a, 18b, 18c and 18d are specific examples of the core of Figure 17. Figure 18a shows a band-shaped laminated core 31c. Figure 18b shows a multiple wire core 31d. Figure 18c shows a solid core 31e, such as a flexible or non-flexible core, where magnetic powder is mixed with resin. Figure 18d shows an example in which a single wire core 31f is used with 31g as the solenoid core. In particular, it is preferable to use a flexible solid core in locations such as the afore-mentioned branch parts.

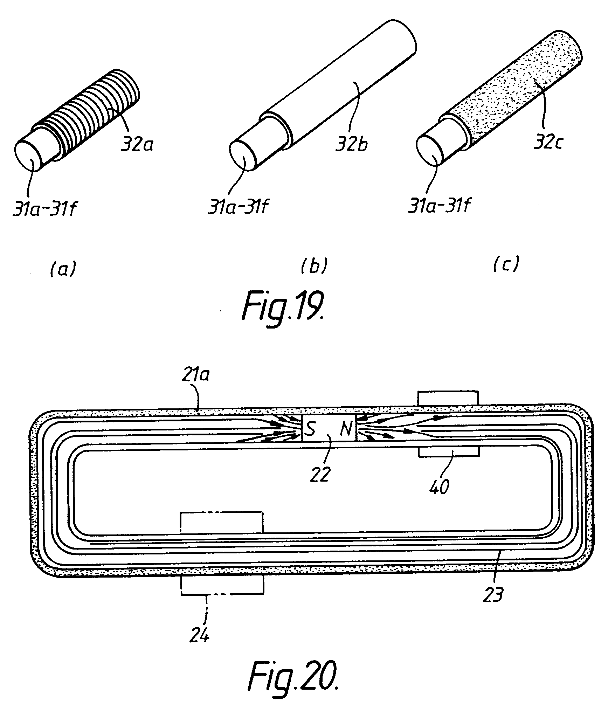

Additionally, as shown, for example, in Figure 19a, a magnetic flux transmission path 21 may be formed by winding a fibre superconductor 32a on a core of the type shown in Figure 16, Figure 17 or Figure 18. Further, as shown in Figure 19b, a method may be employed wherein a superconductor 32b is made to adhere tightly on to a core by drawing through a die. A method may be employed wherein a superconductor 32c is produced that is bonded with a binder, or where superconducting powder is sintered or spray coated on to the circumferential surface of a core, such as shown in Figure 19c.

A further embodiment of the system of this invention is described with reference to Figure 20. Specifically, in this embodiment, a construction is utilised wherein a data transmission device 40 is provided that effects on/off control of magnetic flux 23 in suitable locations of magnetic flux transmission path 21 or magnetic flux generating device 22 itself. In the specific embodiment where, for example, a magnetic flux generating device 22, such as a coil, is used, this data transmission device 40 may effect modulation, or turn the magnetising power source on or off. Alternatively, symbolisation of the transmission content can be performed by means that alter the on/off period, or the magnetic flux may be repetitively made to appear or disappear in magnetic flux transmisison path 21 by altering the magnitude of a voltage. Data having a specific meaning can thus be transmitted by detecting this by a magnetic flux utilising device.

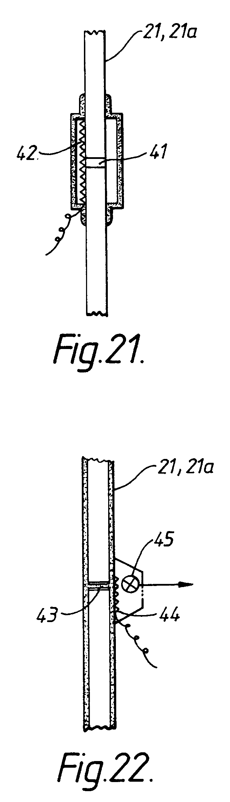

Also, as shown in Figure 21, the flux transmission path 21 can be blocked at suitable locations by forming a non-superconducting part 41. This is brought about by arranging a heater 42 to straddle a part of the superconducting path. When the heater is energised, the path becomes non-superconducting. Data can easily be transmitted by on/off control of the power source that passes current to such a heater 42. When the power source is on, the superconducting property of magnetic flux transmission path 21 is cancelled, allowing magnetic flux to leak to the outside whereas, when the power source is off, the original superconducting magnetic flux transmitting path is re-formed, allowing magnetic flux to be transmitted. Thus, information can easily be transmitted.

Furthermore, it is possible to transmit data by turning the magnetic flux on or off, if, as shown in Figure 22, a shutter 43 consisting of a superconductor, etc., is provided in a removable or fixed manner in the position of non-superconducting part 41, the magnetic flux being turned on or off by inserting or withdrawing shutter 43 in non-superconducting portion 41 during transmission of magnetic flux. Also, by fixedly providing a shutter 43 of superconducting material, etc., by providing a heater 44 in the vicinity of this shutter, so that the power source can thereby be controlled, data can be transmitted by repeatedly causing appearance or disappearance of magnetic flux by restoration and cancellation of the function of the superconductor possessed by shutter 43 itself. In Figure 22, a magnetic sensor is referred to at 45. The intensity of the magnetic field may be controlled by using the signal level of this magnetic sensor 45 or, alternatively, to ascertain the on/off state of the magnetic flux.

Consequently, desired data can be suitably transmitted to a remote location with very little loss, since the data is transmitted utilising magnetic flux.

## Claims

1. A magnetic flux transmission system comprising a magnetic flux generator (22) comprising a first geometric solid having an external surface, an external diameter, an axis, a predetermined width, and a first predetermined axial length, for generating a magnetic field; and transmitting means (21) comprising an elongated second geometric solid, mooted to and coaxially disposed relative the magnetic flux generator (22), characterised in that the transmitting means (21) is a tubular member having at least a portion thereof made of superconducting material, the internal diameter of the internal surface of the portion being substantially the same as the external diameter of the magnetic flux generator (22) which is mounted within the member, the transmitting means (21) having a second predetermined axial length greater than the first predetermined axial length defining a channel for transmitting the generated magnetic field along the channel.

2. A magnetic flux transmission system as claimed in claim 1, characterised in that the internal diameter of the transmission means (21) is substantially the same as the external diameter of the magnetic flux generator (22) for only the first predetermined axial length.

3. A magnetic flux transmission system as claimed in claim 1 or 2, characterised in that the transmitting means (21) is configured to form a closed loop magnetic path.

4. A magnetic flux transmission system as claimed in any of the preceding claims, characterised in that the transmitting means (21) comprises a plurality of individual branches (211 - 21n) joined by a common trunk.

5. A magnetic flux transmission system as claimed in any of the preceding claims, characterised in that the transmitting means (21) contains a core (31a - 31f).

6. A magnetic flux transmission system as claimed in claim 5, characterised in that the core increases the efficiency of transmission of the magnetic flux generated by the magnetic flux generator (22).

7. A magnetic flux transmission system as claimed in claim 5 or 6, characterised in that the core (31d) comprises one or more wires.

8. A magnetic flux transmission system as claimed in claim 5 or 6, characterised in that the core (31c) comprises laminated metallic strips.

9. A magnetic flux transmission system as claimed in any of the preceding claims, characterised in that the system includes a magnetic flux utilizing device (24) associated with the transmitting means (21) at a location spaced from the flux generator (22).

10. A magnetic flux transmission system as claimed in claim 9, characterised in that the system additionally includes means for interrupting the transmission of flux between the generator (22) and the utilizing device (24).

11. A magnetic flux transmission system as claimed in claim 10, characterised in that the interrupting means comprises means (28) for heating a part of the transmitting means to reduce the superconducting properties thereof.

12. A magnetic flux transmission system as claimed in claim 11, characterised in that the heating means (28) comprises an electrical heater wire associated with part of the transmitting means.

13. A magnetic flux transmission system as claimed in claim 12, characterised in that the heater wire is associated with the transmitting means at the flux generator (22).

14. A magnetic flux transmission system as claimed in claim 10, characterised in that the interrupting means comprises a shutter (43) of superconducting material mounted so as to block off the tubular member.

## Patentansprüche

1. Magnetfluß-Übertragungssystem mit einem Magnetflußgenerator (22), der einen ersten geometrischen Körper mit einer Außenfläche, einem Außendurchmesser, einer Achse, einer vorgegebenen Breite und einer ersten vorgegebenen axialen Länge zur Erzeugung eines Magnetfeldes aufweist; und mit einem Übertragungsmittel (21), das einen länglichen zweiten geometrischen Körper aufweist, der an dem Magnetflußgenerator (22) angebracht und in bezug zu diesem koaxial angeordnet ist, **dadurch gekennzeichnet**, daß das Übertragungsmittel (21) ein rohrförmiges Teil ist, bei dem zumindest ein Teil aus supraleitfähigem Material hergestellt ist, wobei der Innendurchmesser der Innenfläche des Teils im wesentlichen gleich wie der Außendurchmesser des Magnetflußgenerators (22) ist, der in dem Mittel angeordnet ist, wobei das Übertragungsmittel (21) eine zweite vorgegebene axiale Länge hat, die größer als die erste vorgegebene axiale Länge ist und einen Kanal für die Übertragung der erzeugten Magnetfeldlinien entlang dem Kanal bildet.

2. Magnetfluß-Übertragungssystem nach Anspruch 1, **dadurch gekennzeichnet**, daß der Innendurchmesser des Übertragungsmittels (21) im wesentlichen derselbe wie der Außendurchmesser des Magnetflußgenerators (22) über lediglich die erste vorgegebene axiale Länge ist.

3. Magnetfluß-Übertragungssystem nach Anspruch 1 oder 2, **dadurch gekennzeichnet**, daß das Übertragungsmittel (21) so gestaltet ist, daß es einen geschlossenen Magnetpfad bildet.

4. Magnetfluß-Übertragungssystem nach einem der vorhergehenden Ansprüche, **dadurch gekennzeichnet**, daß das Übertragungsmittel (21) eine Anzahl einzelner Zweige (21₁-21ₙ) aufweist, die durch einen gemeinsamen Stamm verbunden sind.

5. Magnetfluß-Übertragungssystem nach einem der vorhergehenden Ansprüche, **dadurch gekennzeichnet**, daß das Übertragungsmittel (21) einen Kern (31a-31f) enthält.

6. Magnetfluß-Übertragungssystem nach Anspruch 5, **dadurch gekennzeichnet**, daß der Kern die Wirksamkeit der Übertragung des Magnetflusses erhöht, der von dem Magnetflußgenerator (22) erzeugt ist.

7. Magnetfluß-Übertragungssystem nach Anspruch 5 oder 6, **dadurch gekennzeichnet**, daß der Kern (31d) einen oder mehrere Drähte aufweist.

8. Magnetfluß-Übertragungssystem nach Anspruch 5 oder 6, **dadurch gekennzeichnet**, daß der Kern (31c) laminierte Metallstreifen aufweist.

9. Magnetfluß-Übertragungssystem nach einem der vorhergehenden Ansprüche, **dadurch gekennzeichnet**, daß das System eine Magnetfluß-Verwendungzvorrichtung (24) aufweist, die an einer von dem Flußgenerator (22) beabstandeten Stelle zu dem Übertragungsmittel (21) gehört.

10. Magnetfluß-Übertragungssystem nach Anspruch 9, **dadurch gekennzeichnet**, daß das System außerdem Mittel aufweist, um die Übertragung des Flusses vom Generator (22) zu der Verwendungsvorrichtung (24) zu unterbrechen.

11. Magnetfluß-Übertragungssystem nach Anspruch 10, **dadurch gekennzeichnet**, daß das Unterbrechungsmittel Einrichtungen (28) aufweist, um einen Teil des Übertragungsmittels zu erwärmen und dessen Supraleiteigenschaften zu reduzieren.

12. Magnetfluß-Übertragungssystem nach Anspruch 11, **dadurch gekennzeichnet**, daß das Heizmittel (28) einen elektrischen Heizdraht aufweist, der Teil des Übertragungsmittels ist.

13. Magnetfluß-Übertragungssystem nach Anspruch 12, **dadurch gekennzeichnet**, daß der Heizdraht zu dem Übertragungsmittel beim Flußgenerator (22) gehört.

14. Magnetfluß-Übertragungssystem nach Anspruch 10, **dadurch gekennzeichnet**, daß das Unterbrechungsmittel einen Verschluß (43) aus supraleitfähigem Material aufweist, der so angebracht ist, daß er das rohrförmige Teil absperrt.

## Revendications

1. Système de transmission de flux magnétique qui comprend un générateur de flux magnétique (22) comprenant un premier solide géométrique ayant une surface extérieure, un diamètre extérieur, un axe, une largeur prédéterminée et une première longueur axiale prédéterminée, pour engendrer un champ magnétique, et un moyen de transmission (21) comprenant un second solide géométrique allongé, monté sur et disposé coaxialement par rapport au générateur de flux (22), caractérisé en ce que les moyens de transmission (21) comprennent un élément tubulaire dont une partie, au moins, est faite d'une matière supraconductrice, le diamètre intérieur de la surface intérieure de cette partie étant sensiblement le même que le diamètre extérieur du générateur de flux magnétique (22) qui est monté dans ledit organe, ledit moyen de transmission (21) ayant une seconde longueur axiale prédéterminée, plus grande que la première, définissant un canal pour transmettre le champ magnétique généré le long du canal.

2. Système de transmission de flux magnétique selon la revendication 1, caractérisé en ce que le diamètre intérieur du moyen de transmission (21) est pratiquement le même que le diamètre extérieur du générateur de flux magnétique (22) sur seulement la première longueur axiale pré-déterminée.

3. Système de transmission de flux magnétique selon la revendication 1 ou 2, caractérisé en ce que le moyen de transmission (21) est formé de manière à produire un trajet formant une boucle magnétique fermée.

4. Système de transmission de flux magnétique selon l'une quelconque des revendications précédentes, caractérisé en ce que le moyen de transmission (21) comprend plusieurs branches individuelles (21l, 21n) reliées par un tronc commun.

5. Système de transmission de flux magnétique selon l'une quelconque des revendications précédentes, caractérisé en ce que le moyen de transmission (21) contient un noyau (31a - 31f).

6. Système de transmission de flux magnétique selon la revendication 5, caractérisé en ce que le noyau augmente l'efficacité de transmission du flux magnétique produit par le générateur (22).

7. Système de transmission de flux magnétique selon la revendication 5 ou 6, caractérisé en ce que le noyau (31d) comprend un ou plusieurs fils de métal.

8. Système de transmission de flux magnétique selon la revendication 5 ou 6, caractérisé en ce que le noyau (31d) comprend un ou plusieurs fils métalliques.

9. Système de transmission de flux magnétique selon l'une quelconque des revendications précédentes, caractérisé en ce qu'il comporte un dispositif (24) utilisant le flux magnétique, qui est associé au moyen de transmission (21) à un emplacement éloigné du générateur de flux (22).

10. Système de transmission de flux magnétique, selon la revendication 9, caractérisé en ce que le système comprend en plus des moyens pour interrompre la transmission de flux entre le générateur (22) et le dispositif d'utilisation (24).

11. Système de transmission magnétique selon la revendication 10, caractérisé en ce que les moyens d'interruption comprennent un moyen 28 pour chauffer une partie des moyens de transmission afin de réduire leurs propriétés supraconductrices.

12. Système de transmission de flux magnétique, selon la revendication 11, caractérisé en ce que le moyen de chauffage (28) comprend un fil électrique chauffant associé à une partie du moyen de transmission.

13. Système de transmission de flux magnétique, selon la revendication 12, caractérisé en ce que le fil chauffant est associé au moyen de transmission à l'endroit du générateur de flux (22).

14. Système de transmission de flux magnétique selon la revendication 10, caractérisé en ce que les moyens d'interruption comprennent un obturateur (43) en matière supraconductrice monté de façon à débloquer l'organe tubulaire.
